(19) Europäisches Patentamt
European Patent Office
Office européen des brevets

(11) **EP 1 998 440 A2**

(12) **DEMANDE DE BREVET EUROPEEN**

(43) Date de publication:
**03.12.2008 Bulletin 2008/49**

(51) Int Cl.:
***H03G 3/20*** (2006.01)

(21) Numéro de dépôt: **08156842.0**

(22) Date de dépôt: **23.05.2008**

(84) Etats contractants désignés:
**AT BE BG CH CY CZ DE DK EE ES FI FR GB GR
HR HU IE IS IT LI LT LU LV MC MT NL NO PL PT
RO SE SI SK TR**
Etats d'extension désignés:
**AL BA MK RS**

(30) Priorité: **25.05.2007 FR 0703735**

(71) Demandeur: **THALES
92200 Neuilly sur Seine (FR)**

(72) Inventeurs:
• **Renard, Alain
26120 Chabeuil (FR)**
• **Kirby, Estelle
26000 Valence (FR)**

(74) Mandataire: **Nguyen Van Yen, Christian
Marks & Clerk France
31-33 Avenue Aristide Briand
94117 Arcueil Cedex (FR)**

(54) **Contrôle automatique de gain asservi sur la densité de probabilité de puissance reçue**

(57) L'invention concerne un récepteur radiofréquence, notamment pour des applications de positionnement par satellite, devant opérer en environnement où les interférences sont denses, notamment lorsqu'il s'agit de pulses émis par des balises DME. Le traitement efficace des interférences suppose de disposer d'une référence de bruit non biaisée. Selon l'invention, celle ci est générée par une analyse de la fonction de la probabilité de puissance de signal dans sa partie comprenant essentiellement des signaux de faible puissance.

FIG.7

EP 1 998 440 A2

**EP 1 998 440 A2**

## Description

La présente invention s'applique aux récepteurs radiofréquence devant recevoir des signaux faibles dans un environnement d'interférences pulsées. C'est notamment le cas des récepteurs de positionnement qui utilisent les signaux reçus de constellations de satellites GNSS (Global Navigation Satellite Systems) telles que les systèmes GPS (Gobal Positionning System) et GPS amélioré, GLONASS (Global Orbiting Navigation Satellite System) et, dans un futur proche, Galileo. Le signal reçu se situe typiquement quelques dizaine de dB en-dessous du bruit thermique du récepteur. Le traitement du signal doit permettre la récupération d'une ou plusieurs porteuses et d'un ou plusieurs codes de modulation desdites porteuses qui comportent des informations caractéristiques du satellite émettant lesdites porteuses. La partie centrale du traitement numérique est une corrélation des signaux reçus avec des répliques locales desdits signaux. Ces traitements supposent un minimum de rapport signal à bruit en entrée de corrélation d'une dizaine de dBHz. Ce minimum n'est pas atteint en présence d'interférences qui saturent le récepteur au point de détériorer très sensiblement le signal utile. C'est typiquement le cas des signaux permettant la localisation par rapport à des points remarquables au sol du système DME (Distance Measuring Equipment). Les balises au sol émettent des signaux en réponse aux signaux d'interrogation émis par les aéronefs. Ces balises sol et les interrogateurs embarqués émettent des signaux de forte puissance instantanée (de l'ordre de la dizaine de kilowatts).dans les bandes de fréquences utilisées pour les signaux de positionnement (aux alentours de 1200 MHz).

Une solution connue à ce problème est notamment la technique dite du « blanking » qui consiste à repérer le signal interférant et à supprimer des traitements ultérieurs le signal reçu perturbé par celui-ci. Cette solution est inopérante lorsque la densité d'interférences augmente au point de recouvrir le manière quasi-permanente le signal utile. Dans ce cas, le blanking conduit à éliminer tout signal utile en même temps que le signal interférant. Ce type de scenario est susceptible de se produire dans une grande partie de l'espace aérien européen, notamment à une altitude de l'ordre de 40.000 pieds où le nombre de balises DME vues par un aéronef peut être de l'ordre de 60 aux moments de densité maximale de trafic. Il est possible pour améliorer l'efficacité du blanking de découper la bande en plusieurs sous-bandes et de réaliser le blanking sur chacune des sous-bandes, ce qui, pour des interférence données, laisse subsister une part plus importante du signal utile et améliore donc le rapport signal sur bruit.

Dans les deux cas il est nécessaire de disposer d'une référence de bruit qui permette de s'affranchir du biais d'estimation du bruit thermique qui apparaît dans les scenarios d'interférences denses. Une solution consiste à calibrer une référence de bruit , mais cette solution n'est stable ni dans le temps, ni en température, ni par rapport à la dynamique à laquelle est soumis le récepteur. Le problème général qui n'est pas résolu par cet art antérieur est de fournir une estimation du bruit thermique sans recourir à la calibration. Une solution telle que celle divulguée notamment par le brevet américain n°5,101,416 est d'effectuer un asservissement du contrôle automatique du gain du récepteur en fonction de la densité de probabilité de l'amplitude du signal. Cette solution n'est cependant pas adaptable à des scenarios de brouillage qui peuvent être variables. La présente invention résout ce problème.

A cette fin, la présente invention propose un dispositif de réception d'un signal radiofréquence comprenant un module d'estimation d'une grandeur caractéristique dudit signal choisie dans le groupe amplitude , puissance, un module de contrôle automatique du gain du récepteur, un module d'analyse de la fonction de densité de probabilité de ladite grandeur caractéristique dont les paramètres sont ajustables pour fournir des entrées au module de contrôle automatique du gain qui assurent un gain sensiblement optimal du récepteur, un module de filtrage de ladite grandeur estimée, caractérisé en ce que le module d'analyse de la fonction de densité de probabilité reçoit en entrée des échantillons de signal partagés par un point de comparaison choisi en deux segments dont le segment inférieur est enrichi en échantillons de grandeur caractéristique inférieure à sa valeur au point de comparaison.

Avantageusement, ledit enrichissement s'effectue par pondération avec un poids fort des résidus négatifs d'une soustraction des échantillons pour lesquels ladite grandeur caractéristique est supérieure au point de comparaison choisi et avec un poids faible les résidus positifs de ladite soustraction.

Avantageusement, le point de comparaison choisi est celui qui partage les échantillons du signal en environ 10% de plus faible probabilité et 90% environ de plus forte probabilité.

Avantageusement, la probabilité de la CAG est ajustée à environ 0,886.

Avantageusement, le point de comparaison choisi est celui qui partage les échantillons du signal en environ 25% de plus faible probabilité et 75% environ de plus forte probabilité.

Avantageusement, la probabilité de la CAG est ajustée à environ 0,9408.

Avantageusement, le module d'analyse de la fonction de densité de probabilité réalise successivement plusieurs pondérations avec un poids fort des résidus négatifs de soustractions de suites d'échantillons pour lesquels la grandeur caractéristique est supérieure à plusieurs points de comparaisons choisis et génère une innovation de la CAG par une combinaison choisie desdites pondérations.

Avantageusement, trois points de comparaison sont choisis, l'un sensiblement à la puissance du bruit estimé, le deuxième sensiblement à 90% de ladite puissance et le troisième sensiblement à 80% de ladite puissance..

Avantageusement, le module de traitement des signaux interférents réalise un blanking dont le seuil est calculé par référence au bruit estimé par le module d'analyse de la fonction de densité de probabilité.

Avantageusement, le module de traitement des signaux interférents réalise plusieurs blanking dans des sous-bandes de fréquence du signal, chaque seuil de blanking étant calculé par référence au bruit estimé par le module d'analyse de la fonction de densité de probabilité.

Avantageusement, le seuil de blanking est choisi à une valeur sensiblement égale à 8 dB.

Avantageusement, le seuil de blanking est choisi à une valeur sensiblement égale à 2 dB.

Avantageusement le module de traitement des signaux interférents réalise une inversion d'une grandeur caractéristique du signal choisie dans le groupe amplitude, puissance à partir de la sortie du module d'estimation.

L'invention divulgue également un procédé de traitement d'un signal radiofréquence comprenant une étape d'estimation d'une grandeur caractéristique dudit signal choisie dans le groupe amplitude , puissance, une étape de contrôle automatique du gain du récepteur, une étape d'analyse de la fonction de densité de probabilité de ladite grandeur caractéristique dont les paramètres sont ajustables pour fournir des entrées à l'étape de contrôle automatique du gain qui assurent un gain sensiblement optimal du récepteur et une étape de filtrage de ladite grandeur estimée, caractérisé en ce que l'étape d'analyse de la fonction de densité de probabilité reçoit en entrée des échantillons de signal partagés par un point de comparaison choisi en deux segments dont le segment inférieur est enrichi en échantillons de grandeur caractéristique inférieure à sa valeur au point de comparaison.

L'invention présente en outre l'avantage de permettre une réduction de la dynamique des opérateurs de traitement du signal en raison de l'adaptation du gain qui en résulte.

L'invention sera mieux comprise et ses différentes caractéristiques et avantages ressortiront de la description qui suit de plusieurs exemples de réalisation et de ses figures annexées dont :

- La figure 1 représente l'amplitude en fonction du temps des interférences pulsées émises par une balise DME;
- La figure 2 représente l'histogramme des puissances des émetteurs d'interférences pulsées reçues par un aéronef au point le plus brouillé de l'espace aérien européen en fonction de la fréquence ;
- La figure 3 représente l'histogramme de la puissance en fonction de l'amplitude du signal avec et sans signal pulsé interférant dans la bande E5b du signal Galileo ;
- La figure 4 représente une vue agrandie de la figure 3;
- La figure 5 représente l'histogramme de la figure 3 en probabilité cumulée ;
- La figure 6 représente une vue agrandie de la partie gauche de la courbe de la figure 5 ;
- La figure 7 représente un schéma de principe de l'architecture fonctionnelle de la partie d'un récepteur radiofréquence de positionnement mettant en oeuvre l'invention;
- La figure 8 représente l'architecture fonctionnelle de la partie d'un récepteur radiofréquence de positionnement mettant en oeuvre l'invention dans un mode de réalisation à un seul point de comparaison ;
- La figure 9 représente l'architecture fonctionnelle de la partie d'un récepteur radiofréquence de positionnement mettant en oeuvre l'invention dans un mode de réalisation à plusieurs points de comparaison ;

Dans la description et les figures, les sigles, acronymes, formules et abréviations ont la signification indiquée dans le tableau ci-dessous.

| Sigle | Signification |
|---|---|
| $\alpha$, $\beta$, $\gamma$ | Paramètres des fonctions de comparaison du bruit dans l'architecture à plusieurs points de comparaison |
| $\Delta$ | Innovation introduite dans l'estimation du bruit dans l'architecture à plusieurs points de comparaison |
| $\lambda$ | Longueur d'onde de la porteuse |
| $\sigma$ | Ecart-type du bruit en sortie du filtre passe-bas |
| $Alpha_i$ | Paramètres de réglage du CAG |
| Blanking | Suppression du signal utile en présence d'interférences |
| CAG | Contrôle Automatique du Gain |
| CAN ou ADC | Convertisseur Analogique Numérique ou Analog Digital Converter |
| CM | Core Module |
| Diff_bruit | Différence de codage du bruit thermique |
| DME | Distance Measuring Equipment |

(suite)

| Sigle | Signification |
|---|---|
| e | Signal reçu |
| EUROCAE | European Organisation for Civil Aviation Equipment |
| f(a) | Fonction non linéaire optimale du bruit gaussien |
| FDAF | Frequency Domain Adaptative Filtering |
| FIR | Finite Impulse Response filter ou Filtre à réponse impulsionnelle finie |
| FPGA | Field-Programmable Gate Array |
| GNSS | Global Navigation Satellite System |
| GPS | Global Positioning System |
| $ISW_i$ | Paramètres de consigne en entrée de la partie haute du CM |
| JTIDS | Joint Tactical Information Distribution System |
| LSB | Least Significant Bit |
| MIDS | Multifunctional Information Distribution System |
| OL | Oscillateur Local |
| $OSW_i$ | Sorties de la partie haute du CM |
| $P_{01}$, $P_{02}$, $P_{03}$, | Puissance du bruit aux points de comparaison de la gaussienne |
| P(a) | Bruit de forme gaussienne |
| $Pw_1$, $Pw_2$, $Pw_3$, | Points de comparaison de la gaussienne |
| $P_{consi}$ | Puissance de consigne |
| $P_e$ | Puissance du signal d'entrée |
| $P_s$ | Puissance du signal de sortie |
| TACAN | Tactical Air Navigation |
| UWB | Ultra Wide Band |
| VGA | Voltage Gain Amplifier |

Les systèmes GNSS utilisent actuellement des bandes de fréquence qui sont très proches des fréquences allouées aux balises de radionavigation DME. Les fréquences GPS et GPS futur sont par bande: E6 (1260-1300 MHz), L2 (1216-1240 MHz) et L5/E5a (1164-1188 MHz). Les fréquences Galileo sont: E6, E5a et E5b (1188-1215 MHz). Les fréquences d'émission DME sont 1025-1150 MHz pour un interrogateur embarqué et les balises au sol émettent dans la bande 962-1213 MHz. (donc dans les bandes E5a et E5b de GALILEO et L5 de GPS). La bande totale est découpée en 126 canaux et émission et réception d'une balise sont décalés de 63 MHz. Les canaux sont donc espacés de 1 MHz. Ce sont des paires d'impulsions, chacune de largeur de spectre de 300kHz.qui sont émises par l'interrogateur embarqué. Les balises au sol leur répondent avec un retard fixe de 50 microsecondes et le récepteur de l'interrogateur embarqué recherche ensuite les paires d'impulsion en réponse qui ont l'espacement correct entre elles La puissance du signal émis par les balises sol est de l'ordre de 15 kW.

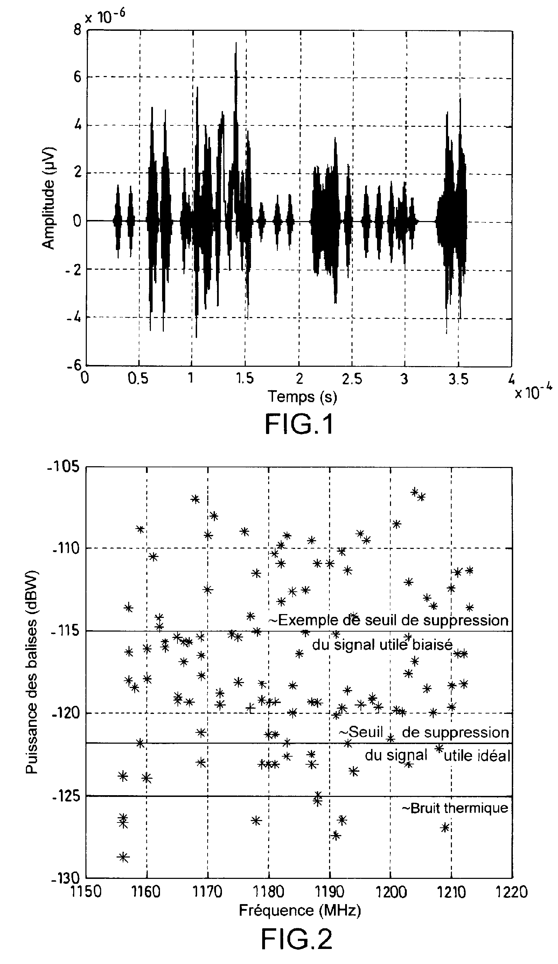

Ces caractéristiques de fonctionnement, schématisées en amplitude/temps sur la figure 1 expliquent le caractère très perturbateur du système DME pour la navigation par satellite, ceci d'autant plus que le taux d'occupation des interférences peut atteindre 100% dans les environnements très denses en balises comme le Nord de l'Europe à haute altitude.

La figure 2 montre le nombre et la puissance des balises DME dans les bandes de fréquence allouées qui sont très proches de L5/E5a au point de densité maximale dans l'espace aérien nord européen dit « hotspot ». Le gain avion est à titre d'illustration fixé à -10dBi sur cette figure. Sur la figure sont également représentés : un exemple de niveau du bruit thermique à l'entrée (# -125dBW), le seuil de blanking résultant de l'estimation biaisée du bruit thermique (# -115 dBW) et le seuil de blanking optimal (# - 122 dBW). L'écart de 7 dB est très significatif par rapport aux performances demandées des récepteurs.

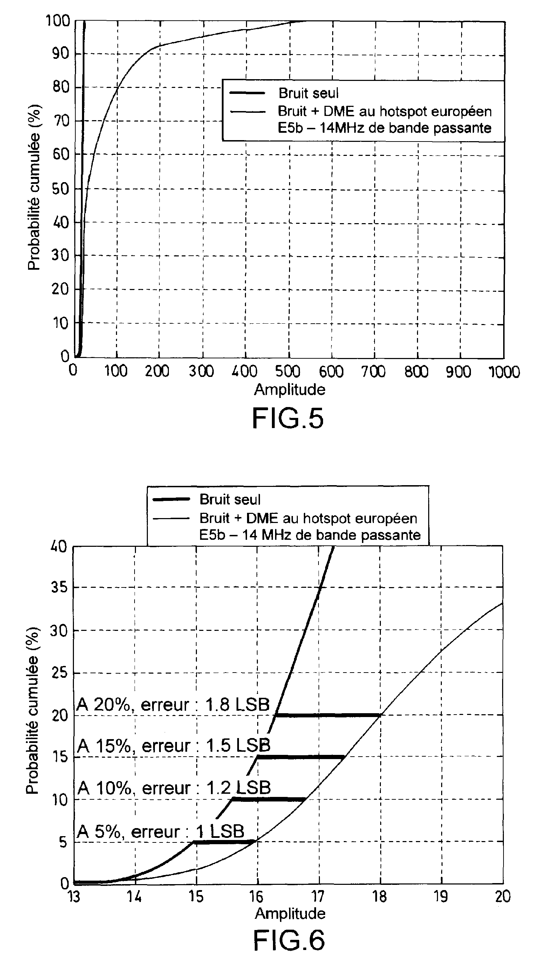

Or un signal GNSS est en-dessous du bruit thermique. Un rapport signal sur bruit minimal est indispensable pour que le traitement du signal, basé pour l'essentiel sur des corrélations, éventuellement aidées, des éléments reçus et de leurs répliques locales, puisse être efficace. En particulier, si le CAN est saturé par les interférences, le signal utile au niveau des corrélateurs sera extrêmement dégradé. Cette impossibilité d'atteindre le signal utile est clairement illustrée sur la figure 5 qui montre les courbes de puissance en sortie de filtrage avec et sans interférences DME. L'horizon temporel est d'environ 2 $\mu$s. Des situations analogues peuvent se produire en présence de radars ou de dispositifs pulsés très large bande (UWB)

Actuellement, les récepteurs GNSS utilisent des traitements avant corrélation pour traiter les interférences pulsées, par exemple, la méthode « blanking » ou la méthode « FDAF ».

Le blanking est un procédé simple consistant à couper le signal pendant l'interférence. Le procédé ne peut fonctionner lorsque les interférences sont trop denses car le signal utile est alors complètement perdu. La méthode FDAF constitue une amélioration de ce procédé. Elle consiste à découper la bande de réception en sous-bandes et à appliquer le procédé de blanking à chaque sous-bande.

Cependant, ces méthodes, si elles permettent de détecter des interférences pulsées et de les éliminer, supposent que l'on connaisse précisément la puissance du bruit thermique. Par exemple, si un pulse a une amplitude supérieure à celle du bruit, alors on peut dire avec une faible probabilité de fausse alarme qu'un pulse est présent et on peut l'éliminer. Cela revient à exiger une CAG « idéale ». Dans certains cas, on peut se tromper sur la connaissance de la puissance du bruit. sans que cela remette en cause l'efficacité du blanking global ou par bande. C'est le cas pour des scénarios où les interférences pulsées sont très puissantes et donc facilement détectables: les méthodes temporelles marchent bien car les pulses sont détectés et pas pris en compte dans l'estimation du bruit thermique. C'est également le cas dans des scénarios où les interférences pulsées sont peu nombreuses et peu puissantes : l'estimation du niveau de bruit est légèrement biaisée mais cela n'empêche pas le fonctionnement du récepteur, même si celui-ci est un peu dégradé.

En revanche , pour des scénarios où les interférences pulsées sont nombreuses et peu puissantes (difficilement détectables), l'estimation du nombre de bits sur lequel est codé le bruit est fortement biaisée. Les méthodes temporelles ne sont plus efficaces. (probabilité de non détection en très forte augmentation). Les interférences pulsées sont détectées relativement à l'estimation du bruit thermique. Comme l'estimation du bruit thermique est plus forte que le bruit thermique lui-même quand des pulses peu puissantes apparaissent et ne sont pas détectés, le seuil de blanking est donc plus élevé qu'il ne devrait être comme illustré sur la figure 2. Donc des interférences pulsées entrent dans le calcul de la CAG. La CAG réagit en descendant le gain du VGA. Donc, encore plus d'interférences pulsées entrent dans l'estimation du bruit thermique et ainsi de suite. Ceci continue à diverger jusqu'à ce que le récepteur accepte la majorité des interférences pulsées et ne code plus le signal utile.

Ce problème a été traité dans des prototypes. L'idée a été d'estimer le bruit thermique en absolu, de donner un seuil de blanking en absolu et de faire attention que le bruit thermique n'évolue pas pendant les essais. Afin d'estimer le bruit thermique en absolu, l'estimation du gain de la chaîne HF est effectué par calibration en laboratoire et l'estimation du facteur de bruit en mesurant le bruit de la chaîne avec l'antenne débranchée. Cette association de deux mesures ponctuelles permet de connaître exactement le bruit dans la chaîne HF à un moment donné et d'effectuer le blanking en fonction de cette estimation de bruit. Néanmoins, ces dispositifs ne sont pas opérationnels car ils ne sont pas robustes en cas d'apparition d'une interférence continue, de vieillissement des composants ou, de variations thermiques répétées, notamment.

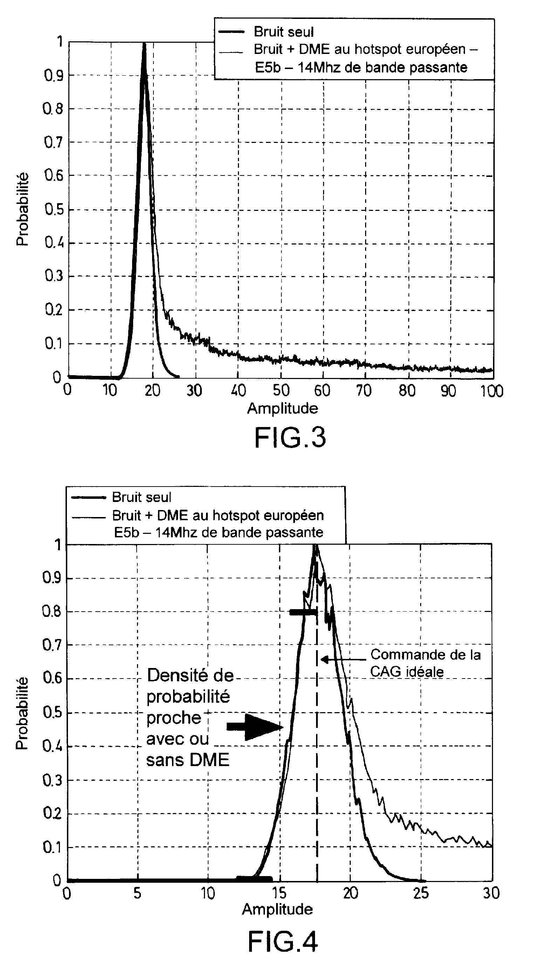

Pour résoudre ce problème non résolu dans l'art antérieur, l'idée de l'invention est d'améliorer l'estimation du bruit thermique et des interférences continues en présence d'interférences pulsées quels que soient leurs puissances et leurs taux de répétition. Elle part du principe que les échantillons filtrés de faible amplitude sont peu sensibles aux interférences pulsées et que la caractéristique de l'énergie du bruit thermique est quasi gaussienne, comme le montre la figure 4.

Le but de la CAG est de chercher à détecter la partie gauche de l'histogramme telle que représentée sur la figure 4 puis d'extrapoler la commande pour le VGA. La figure 5 représente les mêmes données en probabilité cumulée. Sur ces figures on a choisi de représenter la fonction de probabilité de puissance. L'analyse de la fonction de probabilité de l'amplitude du signal reçu pourrait être utilisée de manière complètement substituable et donnerait des résultats équivalents.

Un zoom est effectué sur la première partie de la courbe (figure 6). Les courbes se ressemblent mais ne sont pas parfaitement identiques.

Il y a plusieurs manières de réaliser l'invention. On s'attache dans la suite de la description à en décrire deux principales. Un premier mode consiste à choisir un point de comparaison sur la courbe et à asservir la CAG en utilisant une pondération plus forte des échantillons de plus faible amplitude que le point choisi. Un deuxième mode consiste à estimer la courbe de puissance filtrée par ajustement à une courbe théorique que l'on paramètre sur plusieurs points, par exemple trois.

De manière commune aux deux modes, on cherche à s'asservir sur le ou les points de comparaison choisis en le ou les caractérisant par le ratio de la partie gauche et de la partie droite. Une solution est de donner plus de poids à un événement de valeur inférieure à ceux dépassant le point choisi par une fonction non linéaire adéquate, ceci permet de réduire considérablement l'effet les valeurs élevées dues aux pulses. On peut en pratique parvenir à ce résultat par l'utilisation d'une des fonctions suivantes ou d'une autre qui serait comparable:

- fonction non linéaire tout ou rien : si l'événement est inférieur au point choisi alors il lui affecte un poids k supérieur à 1, dans le cas contraire, il reste inchangé ; ceci va conduire à un équilibre tel que la proportion relative soit la valeur k or celle-ci à été choisie pour obtenir la bonne valeur de la moyenne en présence de bruit seul ;
- fonction saturée dissymétrique : le fonctionnement est voisin du précédent mais permet en régime stable un fonctionnement linéaire au voisinage du point choisi permettant une meilleure stabilité de la CAG , ce qui aboutit à un bon compromis temps de réponse bruit résiduel.

On détermine alors la composante due au bruit et on peut comparer sa moyenne avec la valeur de consigne.

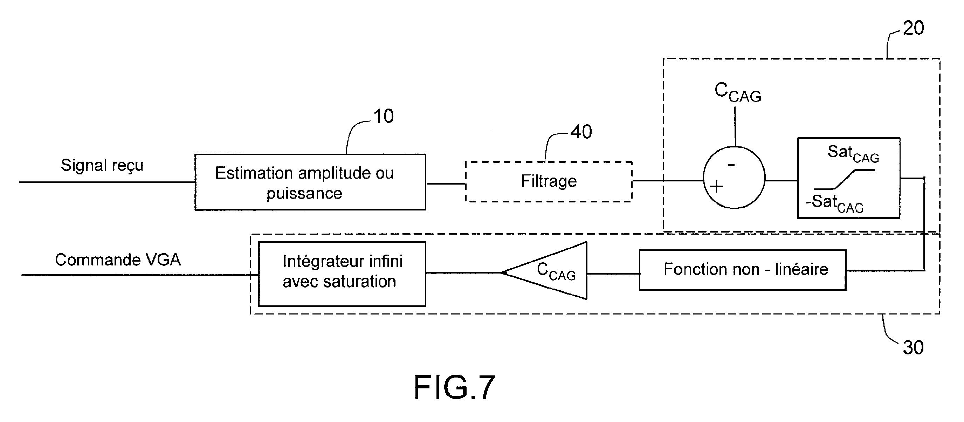

Les éléments d'architecture communs à ces deux modes de réalisation sont représentés sur la figure 7. Le dispositif travaille avantageusement en bande de base. Cela permet d'avoir accès à la puissance instantanée des pulses. Les différentes fonctions représentées sur la figure sont avantageusement réalisées dans un même circuit FPGA. Le premier opérateur 10 est une fonction d'estimation de puissance classique de type $I^2+Q^2$, (alternativement amplitude Racine $(I^2+Q^2)$ ou $|I|+|Q|$). Le récepteur comporte classiquement un module de CAG 20. La fonction 40 réalise le filtrage de l'estimation pour obtenir la moyenne de la densité de probabilité d'amplitude. Ce filtrage est réalisé sur un horizon de temps adapté, par exemple $2,2\mu s$ dans E5b, ce qui représente un échantillon de 128 points. L'estimation est avantageusement effectuée sur un écart type représentant 10% de la moyenne. Avantageusement, les zéros de l'estimée amplitude/puissance (fonction « zéro ») ne sont pas pris en compte dans la moyenne glissante. Ainsi, les pulses hors bande au-dessus du point de compression seront neutralisés.. Dans un module de commande 30, on applique ensuite aux sorties du filtre une ou plusieurs fonctions non linéaires qui vont générer une innovation à partir de paramètres d'optimalité qui dépendent du contexte d'emploi. Si le bruit a une forme P(a), la fonction non linéaire optimale est donnée par la formule

$$f(a) = (dP(a)/da)/P(a)$$

f(a) est une fonction linéaire lorsqu'il n'y a pas de pulses. En présence de pulses, la fonction linéaire est conservée dans la partie gauche de la distribution qui est, en revanche, complètement modifiée dans sa partie droite. Il est également possible d'utiliser une dérivée de f(a).

L'innovation est ensuite introduite dans la CAG. Enfin, les paramètres de traitement du bruit sont déterminés. Le dispositif sera bien entendu différent selon le mode de traitement de bruit choisi. Trois modes de traitement seront décrits dans la suite de la description. Ces modes constituent autant de variantes des modes d'asservissement de la CAG.

Ce dispositif permet de maintenir la poursuite en code et en porteuse d'un récepteur GNSS pour la navigation aérienne sur les fréquences E5a/E5b/L5, notamment sur les hot-spot européens et américains (interférences pulsées). Il fonctionne en présence d'interférences continues. Il n'est pas sensible au changement de température de l'électronique. Il permet également de traiter des interférences pulsées de type radar telles que l'UWB. La réalisation en FPGA est de faible coût. En outre, la CAG est robuste quel que soit le scénario d'interférences pulsées.

Nous commençons par décrire de manière plus détaillée les modes d'asservissement.

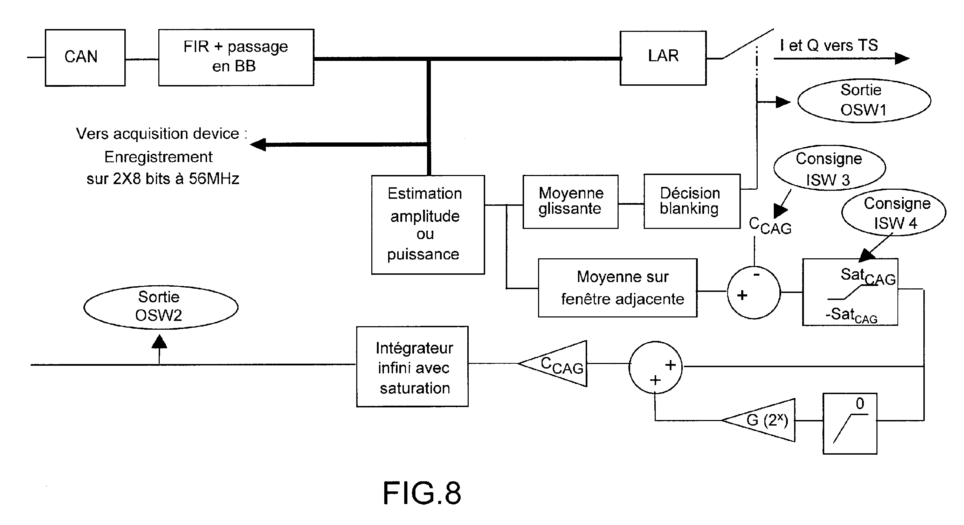

Le mode à un seul point de comparaison est plus précisément décrit sur la figure 8. Dans la suite de la description, le point de comparaison choisi est celui qui partage les échantillons en 10% de plus faible probabilité d'amplitude et 90% de plus forte probabilité. Une autre répartition est possible et le réglage du circuit de commande peut être effectué pour réaliser une adaptation fine au profil d'interférences particulières. Cette répartition est dénommée « Alpha » dans les exemples numériques commentés ci-dessous.

Il faut également choisir d'autres paramètres « Alpha $_1$», « Alpha $_2$» et « Alpha $_3$» pour assurer un gain sensiblement optimal du récepteur qui minimise le biais affectant le seuil de blanking.

« Alpha $_1$» est la probabilité de la CAG qui se calcule comme indiqué dans la suite de la description. « Alpha $_2$» est la pondération de saturation et « Alpha $_3$» est le paramètre de réglage du seuil de blanking.

Nous voulons établir la commande de la CAG en observant les « Alpha »% d'échantillons dont l'amplitude est la plus faible.

Nous soustrayons une commande contenant (1-« Alpha »)% des échantillons pour centrer l'histogramme avec « Alpha »% des échantillons en dessous de 0 et (1-« Alpha »)% des échantillons au-dessus de 0. Ensuite nous saturons très fortement les résidus. Nous pondérons les résidus négatifs avec un poids (1-« Alpha $_2$»), par exemple 0.9, et les résidus positifs avec un poids « Alpha $_2$», dans ce cas 0.1. L'asservissement de la boucle de CAG a un donc un point d'équilibre lorsque ce résidu vaut 0.

« Alpha 2» est lié au filtrage de la puissance avant le calcul de la commande de CAG et à la forme de la gaussienne de bruit. Dans notre cas, le filtrage est effectué sur 128 échantillons (~2μs) donc l'écart-type du bruit thermique est diminué. Lorsque le réglage est autour de quelques pourcents, la gaussienne change fortement, donc « Alpha 2 » doit être petit.

Ceci permet de prendre en compte les occurrences et pas les amplitudes de la fonction de probabilité pour les écarts importants et conserve une petite plage linéaire permettant le filtrage du bruit résiduel de l'estimation de puissance.

Le seuil de blanking « Alpha $_3$» fixé par exemple dans nos applications à une valeur comprise entre 0 et 16.

« Alpha 1 » est calculé de la manière suivante :

- I et Q sont des variables gaussiennes correspondant aux échantillons du récepteur en bande de base

$$E[I] = E[Q] = 0 \ , \ E[I^2] = E[Q^2] = 2^{2*(Nb\_out+Diff\_bruit)} = \sigma^2$$

- $I^2+Q^2$ ont une moyenne de $2^{2*(Nb\_out+Diff\_bruit)+1}$ et un écart-type de $2^{2*(Nb\_out+Diff\_bruit)+1}$

Car:

$$moy(I^2+Q^2)=E[I^2+Q^2]=E[I^2]+E[Q^2]=2*E[I^2]=2^{2*(Nb\_out+Diff\_bruit)+1}=2\sigma^2$$

$$var(I^2+Q^2)=E[(I^2+Q^2-2\sigma^2)^2]=E[I^4]+E[Q^4]+4\sigma^4+2E[I^2Q^2]-4\sigma^2E[I^2]-4\sigma^2E[Q^2]$$

$$= 3\sigma^4+3\sigma^4+4\sigma^4+2\sigma^4-4\sigma^4-4\sigma^4 = 4\sigma^4$$

car

$$E[x_1x_2x_3x_4]= E[x_1x_2] E[x_3x_4]+ E[x_1x_3] E[x_2x_4]+ E[x_1x_4] E[x_2x_3])$$

- $I^2+Q^2$ est moyenné, dans cet exemple, sur 128 échantillons, la moyenne n'a pas change mais écart-type devient :

$$\frac{1}{\sqrt{128}}*2^{2*(Nb\_out+Diff\_bruit)+1}$$

Car :

$$moy\left(\sum_N (I^2+Q^2)\right) = E\left[\sum_N (I^2+Q^2)\right] = \sum_N E[I^2+Q^2] = N2^{2*(Nb\_out+Diff\_bruit)+1} = 2N\sigma^2$$

$$\mathrm{var}\left(\sum_{N}\left(I^2+Q^2\right)\right) = E\left[\left(\sum_{N}\left(I^2+Q^2\right)-2N\sigma^2\right)^2\right] = E\left[\left(\sum_{N}\left(\left(I^2+Q^2\right)-2\sigma^2\right)\right)^2\right]$$

$$= \mathrm{var}\left(\sum_{N}\left(\left(I^2+Q^2\right)-2\sigma^2\right)\right) = NE\left[\left(\sum_{N}\left(\left(I^2+Q^2\right)-2\sigma^2\right)\right)^2\right]$$

$$= 4N\sigma^4$$

- Les tables classiques associent à chaque valeur aléatoire sa probabilité dans le cas d'une gaussienne centrée et d'écart-type 1. Pour obtenir une probabilité de 10% par exemple, nous prenons l'opposé de la valeur à 90% (-1.29), nous la multiplions par l'écart-type et nous ajoutons le décentrage de la gaussienne. Dans cet exemple, nous avons donc se placer :

$$-1.29\frac{1}{\sqrt{128}}*2^{2*(Nb\_out+Diff\_bruit)+1} + 2^{2*(Nb\_out+Diff\_bruit)+1}$$

$$\left(1-\frac{1.29}{\sqrt{128}}\right)2^{2*(Nb\_out+Diff\_bruit)+1} = 0.8860$$

Les exemples de réglage figurant dans le tableau ci-dessous sont donnés à titre purement illustratif :

| Réglage CAG : « alpha » | Probabilité CAG « alpha 1 » | Saturation « alpha 2 » | Réglage du seuil de blanking « alpha 3 » | Type de CAG |
|---|---|---|---|---|
| 6% | 0.863 | 0.06 | 16 | |
| 10% | 0.886 | 0.1 | 8 | CAG choisie pour le scénario DME/ TACAN |
| 17% | 0.916 | 0.1 | 4 | |
| 25% | 0.9408 | 0.1 | 2 | CAG choisie lorsque les scénarios de pulses ne sont pas clairs |
| 33% | 0.9346 | 0.1 | 1 | |
| 50% | 1 | 0.5 | 0 | CAG classique |

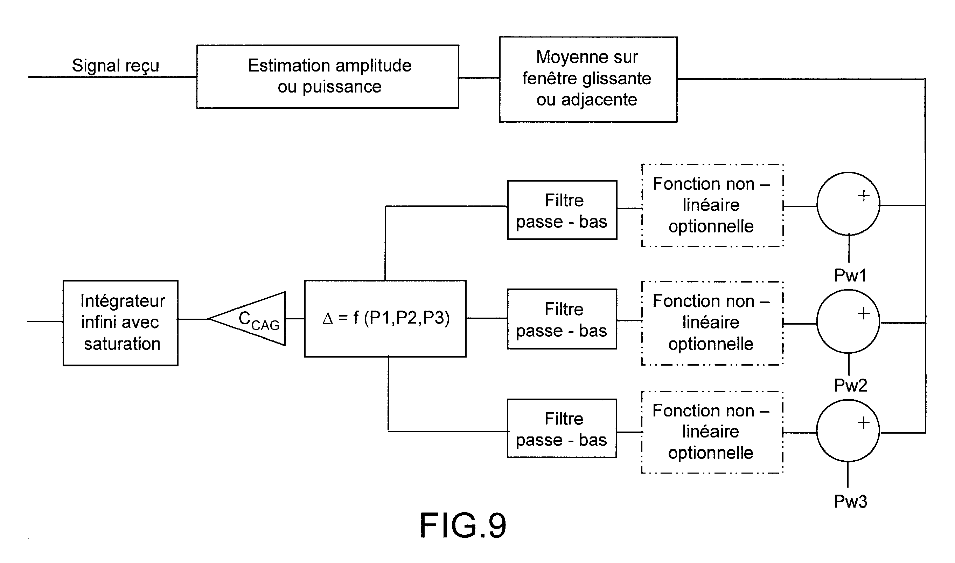

Le mode de réalisation à plusieurs points de comparaison est spécifiquement décrit sur la figure 9. Ce mode de réalisation utilise la caractéristique de la fonction de probabilité de puissance qu'une somme d'un bruit et d'interférences pulsées est proche de la composante de bruit pour les valeurs de faible amplitude. On choisit typiquement de traiter trois points de comparaison différents, ce qui est suffisant. Dans cette option, l'innovation combine les résultats des trois points de comparaison $Pw_1$, $Pw_2$, $Pw_3$. On peut appliquer ou ne pas appliquer à chaque point de comparaison un opérateur non linéaire comme dans le cas du fonctionnement à un seul point de comparaison.

A titre d'exemple, on peut utiliser comme fonction non linéaire, la fonction s = signe(e), où e est le signal reçu et s peut prendre les valeurs -1, 0 ou 1. Si $\sigma$ est l'écart-type du bruit filtré par le passe-bas, P0 est la puissance du bruit que l'on recherche et $\alpha$, $\beta$, $\gamma$ sont trois paramètres positifs on a le système d'équation ci-dessous :

$$Pw1 = (1 - \gamma\sigma)Po \qquad Po1 = F(-\gamma)$$

$$Pw2 = (1 - \beta\sigma)Po \qquad Po2 = F(-\beta)$$

$$Pw3 = (1 - \alpha\sigma)Po \qquad Po3 = F(-\alpha)$$

*avec* $0 \leq \alpha, \beta, \gamma$

$$\Delta = \frac{1}{Po1}P1 + \frac{1}{Po2}P2 + \frac{1}{Po3}P3$$

Ainsi, en choisissant $\alpha$=0, $\beta$=1, $\gamma$=2, on obtient :

Pw1=0.8Po, Pw2=0.9Po, Pw3=Po

$$\Delta = 43.8P1 + 6.25P2 - 2P3$$

Dans le cas d'un bruit gaussien pur, on a Pe=Po ; dans le cas d'un bruit gaussien avec un pulse, on a Pe=Po (1-$\epsilon$). En négligeant $\epsilon$, on réalise un compromis acceptable entre l'erreur et le bruit résiduel, compte tenu de la partie de la courbe de densité de probabilité où l'on se situe.

On peut également s'asservir sur un critère de ratio de probabilité par rapport à une consigne. Une solution combinée entre les deux précédentes - trois points de comparaison avec un critère de convergence sur un ratio de probabilité est également possible. La stabilité en poursuite en est améliorée. En utilisant ces différentes méthodes de mise en oeuvre de l'invention, des biais de quelques LSB peuvent apparaître. Néanmoins, ce biais est largement acceptable car le biais est largement inférieur à celui qui apparaît avec un contrôle automatique de gain classique (6 à 7 dB).

Une fois le bruit connu avec un biais réduit, l'interférence est facilement isolée. Le blanking simple est alors réalisé par suppression du signal dans la plage temporelle où l'interférence est présente. L'homme de l'art sait réaliser le dispositif nécessaire pour effectuer cette suppression.

Pour réaliser un blanking par sous-bande du domaine fréquentiel, on peut, par exemple, prévoir un filtre de détection par sous-bande. Si l'on n'a aucune connaissance a priori des caractéristiques des signaux interférents, on utilisera des filtres passe-bande standard. Si, en revanche, on connaît les caractéristiques des signaux interférents.(fréquence et forme des pulses), on pourra utiliser des FIR. Des filtres réjecteurs permettent ensuite la coupure du signal sur les plages où les signaux interférents sont présents. Un bruit à biais réduit est estimé dans chacune des sous-bandes de fréquence et ce bruit sert de référence pour la suppression du signal reçu dans chacune des sous-bandes.

Un troisième mode de traitement des interférences consiste à inverser l'amplitude ou la puissance du signal reçu, les interférences d'amplitude/puissance élevée étant alors écrêtées. L'inversion d'amplitude ou de puissance consiste à multiplier le signal d'entrée par l'inverse de l'estimation d'amplitude ou de puissance filtrée. Dans le cas où l'inversion porte sur la puissance du signal, la puissance du signal de sortie est égale à l'inverse de la puissance du signal d'entrée, à une constante près. Le gain du récepteur est donné par rapport à une puissance de consigne par la formule :

$$G = P_{consi}/P_e$$

Dans le cas où l'inversion porte sur l'amplitude du signal, la puissance du signal de sortie est égale à l'inverse du carré de la puissance du signal d'entrée, à une constante près. Le gain du récepteur est donné par rapport à un puissance de consigne par la formule :

$$G = (P_{consi}/P_e)^2$$

L'inversion de puissance est théoriquement optimale. En revanche, l'inversion d'amplitude est moins sensible aux imperfections de réalisation. L'inversion de puissance ne peut cependant se substituer complètement au blanking : lorsque le CAN est saturé par les interférences pulsées, il est nécessaire d'effectuer un blanking afin de limiter les fréquences parasites qui, sinon, entreraient dans la corrélation. Pour cette raison et pour disposer d'une référence pour fixer $P_{consi}$,. il est nécessaire de disposer d'une référence de bruit non biaisée. La consigne à laquelle est asservie le produit des signaux source et inversé est constituée à partir de l'estimation du bruit réalisée par le dispositif de l'invention. Il est possible de réaliser une inversion par sous-bande de fréquence. Ce dernier traitement est particulièrement avantageux pour les signaux BOC (Binary Offset Carrier) pour lesquels on réalisera l'inversion sur quatre bandes de fréquence (deux bandes larges et deux bandes étroites).

D'autres modes de traitement du bruit sont possibles en sortie de la commande optimale de la CAG qui permet d'estimer le bruit thermique avec un biais réduit. L'invention n'est donc pas limitée aux modes de réalisation divulgués dans la présente description.

**Revendications**

1. Dispositif de réception d'un signal radiofréquence comprenant un module (10) d'estimation d'une grandeur caractéristique dudit signal choisie dans le groupe amplitude , puissance, un module (20) de contrôle automatique du gain du récepteur, un module (30) d'analyse de la fonction de densité de probabilité de ladite grandeur caractéristique dont les paramètres sont ajustables pour fournir des entrées au module de contrôle automatique du gain qui assurent un gain sensiblement optimal du récepteur, un module (40) de filtrage de ladite grandeur estimée, **caractérisé en ce que** le module d'analyse de la fonction de densité de probabilité fournit une innovation au module de contrôle automatique de gain calculée à partir d'échantillons de signal partagés par un point de comparaison choisi en deux segments dont le segment inférieur est enrichi en échantillons de grandeur caractéristique inférieure à sa valeur au point de comparaison.

2. Dispositif de réception selon la revendication 1 **caractérisé en ce que** ledit enrichissement s'effectue par pondération avec un poids fort des résidus négatifs d'une soustraction des échantillons pour lesquels ladite grandeur caractéristique est supérieure au point de comparaison choisi et avec un poids faible les résidus positifs de ladite soustraction.

3. Dispositif de réception selon la revendication 1 **caractérisé en ce que** le point de comparaison choisi est celui qui partage les échantillons du signal en environ 10% de plus faible probabilité et 90% environ de plus forte probabilité.

4. Dispositif de réception selon la revendication 3 **caractérisé en ce que** la probabilité de la CAG est ajustée à environ 0,886.

5. Dispositif de réception selon la revendication 1 **caractérisé en ce que** le point de comparaison choisi est celui qui partage les échantillons du signal en environ 25% de plus faible probabilité et 75% environ de plus forte probabilité.

6. Dispositif de réception selon la revendication 5 **caractérisé en ce que** la probabilité de la CAG est ajustée à environ 0,9408.

7. Dispositif de réception selon la revendication 2 **caractérisé en ce que** le module d'analyse de la fonction de densité de probabilité réalise successivement plusieurs pondérations avec un poids fort des résidus négatifs de soustractions de suites d'échantillons pour lesquels la grandeur caractéristique est supérieure à plusieurs points de comparaisons choisis et génère une innovation de la CAG par une combinaison choisie desdites pondérations.

8. Dispositif de réception selon la revendication 7 **caractérisé en ce que** trois points de comparaison sont choisis, l'un sensiblement à la puissance du bruit estimé, le deuxième sensiblement à 90% de ladite puissance et le troisième sensiblement à 80% de ladite puissance..

9. Dispositif de réception selon l'une des revendications 1 à 8 **caractérisé en ce qu'**il comprend en outre un module de traitement de signaux interférents en sortie du module d'analyse de la fonction de densité de probabilité.

10. Dispositif de réception selon la revendication 9 **caractérisé en ce que** le module de traitement des signaux interférents réalise un blanking dont le seuil est calculé par référence au bruit estimé par le module d'analyse de la fonction de densité de probabilité.

11. Dispositif de réception selon les revendications 3 et 10 **caractérisé en ce que** le seuil de blanking est choisi à une valeur sensiblement égale à 8 dB.

12. Dispositif de réception selon les revendications 5 et 10 **caractérisé en ce que** le seuil de blanking est choisi à une valeur sensiblement égale à 2 dB.

13. Dispositif de réception selon la revendication 9 **caractérisé en ce que** le module de traitement des signaux interférents réalise plusieurs blanking dans des sous-bandes de fréquence du signal, chaque seuil de blanking étant calculé par référence au bruit estimé par le module d'analyse de la fonction de densité de probabilité.

14. Dispositif de réception selon la revendication 9 **caractérisé en ce que** le module de traitement des signaux interférents réalise une inversion d'une grandeur caractéristique du signal choisie dans le groupe amplitude, puissance à partir de la sortie du module d'estimation.

15. Procédé de traitement d'un signal radiofréquence comprenant une étape d'estimation d'une grandeur caractéristique dudit signal choisie dans le groupe amplitude , puissance, une étape de contrôle automatique du gain du récepteur, une étape d'analyse de la fonction de densité de probabilité de ladite grandeur caractéristique dont les paramètres sont ajustables pour fournir des entrées à l'étape de contrôle automatique du gain qui assurent un gain sensiblement optimal du récepteur et une étape de filtrage de ladite grandeur estimée, **caractérisé en ce que** l'étape d'analyse de la fonction de densité de probabilité reçoit en entrée des échantillons de signal partagés par un point de comparaison choisi en deux segments dont le segment inférieur est enrichi en échantillons de grandeur caractéristique inférieure à sa valeur au point de comparaison.

FIG.1

FIG.2

FIG.3

FIG.4

FIG.5

FIG.6

FIG.7

FIG.8

FIG.9